# EUROPÄISCHE PATENTSCHRIFT

(11) **EP 0 990 061 B1**
(45) Veröffentlichungstag und Bekanntmachung des Hinweises auf die Patenterteilung: **04.01.2006**
(21) Anmeldenummer: 98936157.1
(22) Anmeldetag: 15.06.1998
(51) Int. Cl.: C23C 16/50, C23C 28/00, C23C 16/24, C23C 16/26, C23C 16/30, C23C 16/32, C23C 16/34, C23C 16/36, C23C 16/42, H01J 37/32

(54) **VERFAHREN UND EINRICHTUNG ZUM VAKUUMBESCHICHTEN EINES SUBSTRATES**
METHOD AND DEVICE FOR VACUUM-COATING A SUBSTRATE
PROCEDE ET DISPOSITIF POUR REVETIR UN SUBSTRAT PAR DEPOT SOUS VIDE

(30) Priorität: 16.06.1997 DE 19725383
(43) Veröffentlichungstag der Anmeldung: 05.04.2000
(73) Patentinhaber: ROBERT BOSCH GMBH, 70442 Stuttgart (DE)
(72) Erfinder: BURGER, Kurt, D-71292 Friolzheim (DE); WEBER, Thomas, D-70825 Korntal-Münchingen (DE); VOIGT, Johannes, D-71229 Leonberg (DE); LUCAS, Susanne, D-70195 Stuttgart (DE)
(86) Internationale Anmeldenummer: PCT/DE1998/001610
(87) Internationale Veröffentlichungsnummer: WO 1998/058100

(56) Entgegenhaltungen:
- EP-A- 0 678 903
- EP-A- 0 701 982
- EP-A- 0 827 817
- WO-A-95/26879
- DE-C- 19 609 804
- US-A- 4 619 865
- US-A- 4 863 549
- US-A- 5 102 687
- US-A- 5 693 376

## Beschreibung

### Stand der Technik

Die Erfindung geht aus von einem Verfahren nach der Gattung des Hauptanspruchs. Ein Verfahren dieser Art ist bekannt aus der DE-C 195 13 614. Danach erfolgt die Beschichtung eines Substrates mit amorphen Kohlenstoffschichten durch Anlegen einer bipolaren Spannung, deren positive und negative Pulsdauern getrennt voneinander einstellbar sind, an das Substrat. Während der Abscheidung ist die positive Pulsdauer kleiner als die negative Pulsdauer, die Pulsfrequenz liegt im Bereich von 5 bis 100 kHz. Zur Verbesserung der Haftung der erzeugten amorphen Kohlenstoffschicht auf dem Substrat ist vorgesehen, eine modifizierte, metallhaltige Kohlenstoffzwischenschicht aufzubringen. Bei diesem bekannten Verfahren werden Plasmaerzeugung und Ionenbeschuß der aufwachsenden Schicht gemeinsam durch die angelegte bipolare Spannung realisiert und sind nicht einzeln kontrollierbar. Für viele Schichtqualitäten ist die Schichtabscheidung mit diesem Verfahren deshalb auf ein vergleichsweise enges Prozeßfenster beschränkt.

Aus der Deutschen Patentanmeldung AZ 196 09 804.1 ist ein Verfahren zum Plasmabeschichten von Schüttgut bekannt, bei dem sich ein Drehkorb langsam um eine Plasmabeschichtungsquelle herumbewegt. An den Drehkorb ist eine Spannung anlegbar, um das zu beschichtende Schüttgut auf ein elektrisch negatives Potential zu bringen. Innerhalb des Drehkorbes befinden sich Mittel zur Erzeugung eines Reinigungsplasmas, mittels dessen das Schüttgut vor Beginn der Schichtabscheidung gereinigt wird. Das Reinigungsplasma wird dabei unabhängig von der an den Drehkorb und das Schüttgut angelegten Spannung erzeugt. Eine negative elektrische Aufladung des zu beschichtenden Schüttgutes ist allgemein auch für den nachfolgenden Beschichtungsschritt vorgesehen. Weitere Angaben zur Art und Weise, wie die negative Aufladung erfolgen soll, sind nicht offenbart.

Ein Verfahren zur Herstellung von harten, amorphen Kohlenstoffschichten ist in R.S. Bonetti, M. Tobler, Oberfläche und JOT, Heft 9, 1988, S.15, beschrieben. In einem plasmaunterstützten CVD-Verfahren werden Plasmaerzeugung und negative Substratvorspannung gemeinsam durch eine an die Substrate gelegte Radiofrequenz(RF)-Leistungsversorgung realisiert. Das Substratpotential gewährleistet den zur Abscheidung von dichten, harten und damit verschleißfesten Schichten notwendigen Ionenbeschuß. Hierzu muß das Verhältnis zwischen der Oberfläche der zu beschichtenden Teile und der Innenwandfläche des Rezipienten vorzugsweise kleiner als 1 sein, was die Beladungsdichte und Hochskalierbarkeit des Verfahrens für industielle Chargengrößen in unerwünschter Weise limitiert. Einen weiteren Nachteil stellt die notwendige, beladungsabhängige Anpassung der RF-Einkopplung dar.

Es ist Aufgabe der vorliegenden Erfindung, ein für industrielle Chargengrößen einsetzbares, hochskalierbares Verfahren sowie eine Einrichtung zu seiner Durchführung anzugeben, das es gestattet, Substrate gleichmäßig und mit hohen Raten zu beschichten und eine verschleißfeste und reibmindernde Multilagenstruktur anzugeben.

Die Aufgabe wird gelöst durch ein Verfahren mit den Merkmalen des Hauptanspruchs. Durch die Trennung der Substratspannungserzeugung von der Plasmaerzeugung erlaubt das erfindungsgemäße Verfahren eine gezielte Einflußnahme auf die physikalischen Eigenschaften der erzeugten Schichten. Beeinflussen lassen sich unter anderem die Schichthärte, die Abrasionsbeständigkeit, die Elastizität der Schicht und die Schichteigenspannung. Beschichtbar sind insbesondere auch Substrate mit komplexen Geometrien. Die Trennung von Plasmaerzeugung und Substratspannungerzeugung erlaubt dabei eine Regelung der Substrattemperatur. Dadurch kann die Schichtabscheidung vielfach bei Temperaturen von 200 °C und darunter erfolgen. Als Substratspannung wird vorteilhaft eine gepulste bipolare Gleichspannung eingesetzt, die hinsichtlich Größe und Dauer des Negativenimpulses, Größe und Dauer des Positivimpulses, sowie der spannungsfreien Zwischenintervalle bzw. Pausenzeiten änderbar ist. Zur Erweiterung der möglichen erzielbaren Schichten ist zweckmäßig der Zusatz von verschiedenen Prozeßgasen in jeweils geeigneter Mischung und Abfolge vorgesehen.

Durch die Trennung von Plasmaerzeugung und Substratspannungserzeugung ist eine zur Durchführung des Verfahrens geeignete Einrichtung nicht auf die Verwendung einer bestimmten Plasmaerzeugungsquelle eingeschränkt. In Betracht kommen vielmehr alle plasmaerzeugenden Quellen wie beispielsweise Mikrowellenquellen, Hochfrequenzquellen, Hohlkathode oder Hochstrombogen. Als Netzteil zur Erzeugung der Substratspannung dient zweckmäßig ein bipolar gepulstes Gleichspannungsnetzteil mit der Möglichkeit zur Unterlagerung einer Gleichspannung und zur Realisierung spannungsfreier Pausenzeiten. Vorteilhaft sind in der Beschichtungskammer Blenden vorgesehen, die einen Teil der Beschichtungskammer abschirmen. Durch Bewegung der zu beschichtenden Teile durch die damit entstehenden Teilvolumina unterschiedlicher Plasmadichten lassen sich die Eigenschaften der erzeugten Schichten auf einfache Weise beeinflussen.

Beachtliche Vorteile hat eine erfindungsgemäß hergestellte Multilagenstruktur bestehend aus alternierenden Hartstoff- und harten Kohlenstoffschichten, wobei die letzteren gegebenenfalls zusätzlich Wasserstoff und/oder Silicium und/oder Metall enthalten. Bei der Struktur wirken die Verschleißfestigkeit des Hartstoffs und insbesondere die hervorragende Verschleißfestigkeit und reibmindernde, schmierende Wirkung des erfindungsgemäß hergestellten harten Kohlenstoffs mit den Multilagenstruktureigenschaften synergistisch zusammen. Die Multilagenstruktur hat z.B. eine höhere Härte als die Einzelschichten, aus denen sie besteht. Die Multilagenstruktur ist außerdem duktiler und elastischer als eine Einzelschicht vergleichbarer Härte.

Die erfindungsgemäß hergestellten Multilagenstrukturen sind aufgrund des synergistischen Zusammenwirkens der o.g. Eigenschaften bei neuartigen Anwendungsfeldern vorteilhaft einsetzbar. So sind sie generell geeignet als Korrosions- und Verschleißschutz für tribologisch hochbelastete Bauteile und dabei insbesondere als Verschleißschutz von Bauteilen im Trockenlauf-und Mangelschmierungsbereich. Die Multilagenstrukturen eignen sich beispielsweise als schmierende Verschleiß- und Korrosionsschutzschicht für zerspanende und umformende Werkzeuge, deren Lebensdauer dadurch beachtlich erhöht wird, sie ermöglichen die Trockenbearbeitung oder die Bearbeitung bei Minimalschmierung durch mit ihnen beschichtete Werkzeuge, so daß man auf Kühlschmierstoffe ganz verzichten oder zum mindesten die erforderliche Menge stark vermindern kann. Darüber hinaus läßt sich durch die Beschichtung mit den genannten Multilagenstrukturen der Korrosionsschutz von Bauteilen in aggressiven Medien verbessern, und, wenn beschichtete Werkzeuge eingesetzt werden, die Bearbeitungsgeschwindigkeit und die Bearbeitungsqualität von Bauteilen erhöhen.

Erfindungsgemäß besteht die Kohlenstoffschicht aus amorphem wasserstoffhaltigem Kohlenstoff (a-C:H im folgenden), amorphem wasserstoffreiem Kohlenstoff (a-C), siliciumhaltigem (wasserstoffhaltigem oder wasserstoffreiem) Kohlenstoff oder metallhaltigem (wasserstoffhaltigem oder wasserstoffreiem) Kohlenstoff (C-(MeC)) , wobei das Metall aus der Gruppe Wolfram, Chrom, Niob oder Molybdän ausgewählt ist. Diese Auswahl ermöglicht es dem Anwender, flexibel auf gestellte Anforderungen bezüglich der Schmierwirkung und der Härte der Kohlenstoffschicht und (s.o.) auf etwaige Anpassungsschwierigkeiten an die Hartstoffschicht zu reagieren.

Alternativ können in die Multilagenschicht statt der Kohlenstoffschicht auch Siliciumschichten, die gegebenenfalls zusätzlich Wasserstoff und/oder Kohlenstoff und/oder Metall enthalten, eingebaut werden. Diese haben zwar keine Schmierwirkung, sie sind jedoch auch durch hohe Härte (wenn sie auch in der Tendenz etwas weicher als Kohlenstoffschichten sind) und niedrige Reibwerte ausgezeichnet. Als besonderer Vorteil ist die geringe Abhängigkeit der Schichteigenschaften, insbesondere des Reibwerts, von der Umgebungsfeuchte zu nennen.

Es ist vorteilhaft, wenn die Siliciumschicht aus amorphem wasserstoffhaltigem Silicium (a-Si:H im folgenden), amorphem wasserstoffreiem silicium (a-Si), kohlenstoffhaltigem (wasserstoffhaltigem oder wasserstoffreiem) Silicium oder metallhaltigem (wasserstoffhaltigem oder wasserstoffreiem) Silicium (Si-(MeSi)) besteht. Diese Auswahl ermöglicht es - wie beim Kohlenstoff - insbesondere flexibel auf gestellte Anforderungen zu reagieren.

Eine Multilagenstruktur aus harten Schichten, schmierenden Schichten und gegebenenfalls oxidationsresistenten Schichten, wobei die Eigenschaften der Struktur durch die Kombination der Eigenschaften der Einzelschichten bestimmt ist, ist in dem US-Patent 4,619,865 beschrieben, aber harte Kohlenstoff- bzw. Siliciumschichten bzw. die genannten Metalle enthaltende harte Kohlenstoff- bzw. Siliciumschichten werden in dem Patent nicht, insbesondere nicht als reibmindernde Schichten beschrieben.

Bevorzugt bestehen die Einzelschichten bezüglich der Zusammensetzung aus einer Art oder mehr Arten der Hartstoffschicht und einer Art oder mehr Arten der Kohlenstoff- bzw. der Siliciumschicht, wobei am bevorzugtesten die Einzelschichten aus einer Art der Hartstoffschicht und aus einer Art der Kohlenstoff-bzw. der Siliciumschicht bestehen.

Um die Vorteile der Multilagen optimal auszunutzen, ist es günstig, wenn die Dicken der Einzelschichten zwischen etwa 1 und etwa 10 nm und bevorzugt zwischen etwa 2 und etwa 5 nm liegen und wenn die Gesamtdicke der Struktur zwischen etwa 1 und etwa 10 µm, und bevorzugt zwischen etwa 1 und 4 µm liegt.

Erfindungsgemäß besteht die Hartstoffschicht aus einem Metall (Me im folgenden), einer Metallverbindung, Metallcarbid enthaltendem Kohlenstoff (C-(MeC), Metallsilicid enthaltendem Silicium (Si-(MeSi)), wobei bei den beiden letzteren Materialien die angestrebte Härte u.a. beispielsweise durch eine entsprechende Wahl des Metalls erreicht wird, oder Mischungen aus mindestens zwei der genannten Materialien, wobei das Metall aus der Gruppe Wolfram, Chrom, Niobium oder Molybdän ansgewählt ist.. Diese Auswahl ermöglicht es dem Anwender flexibel auf gestellte Anforderungen bezüglich der Härte der Harstoffschicht und auf etwaige Anpassungsschwierigkeiten an die Kohlenstoffschicht bzw. die Siliciumschicht zu reagieren und - wenn vorteilhaft - die Schicht auch noch mit einer gewissen reibmindernden Wirkung auszustatten.

Günstige Kombinationen von Hartstoffschicht und Kohlenstoffschicht sind gegeben, wenn die Hartstoffschicht aus Me, einem Metallcarbid (MeC), einem Metallnitrid (MeN), einem Metallsilicid (MeSi), einem Metallcarbonitrid (Me(CN)), einem Metallcarbosilicid (Me(CSi)) oder einem Metallsiliconitrid (Me(SiN)) und die Kohlenstoffschicht aus a-C:H oder a-C besteht, wenn die Hartstoffschicht aus C-(WC) und die Kohlenstoffschicht aus a-C:H besteht, wobei die Hartstoffschicht wegen der Beteiligung von Wolfram eine große Härte zeigt, aber wegen des nicht chemisch an Metall gebundenen Kohlenstoffanteil auch über eine beachtliche Schmierwirkung verfügt, und wenn die Hartstoffschicht aus MeC und die Kohlenstoffschicht aus C-(MeC) besteht, wobei die Härte - allerdings auf Kosten der Schmierwirkung - besonders ausgeprägt ist.

Günstige Kombinationen von Hartstoffschicht und Siliciumschicht sind gegeben, wenn die Hartstoffschicht aus Me, MeC, MeN, MeSi, Me(CN), Me(CSi) oder Me(SiN) und die Siliciumschicht aus a-Si:H oder a-Si besteht.

Weitere vorteilhafte Ausgestaltungen des erfindungsgemäßen Verfahrens der erfindungsgemäßen Einrichtung und der erfindungsgemäßen Multilagenstruktur sind in Unteransprüchen offenbart.

Unter Bezugnahme auf die Zeichnung wird die Erfindung nachfolgend anhand von Ausführungsbeispielen näher beschrieben.

### Zeichnung

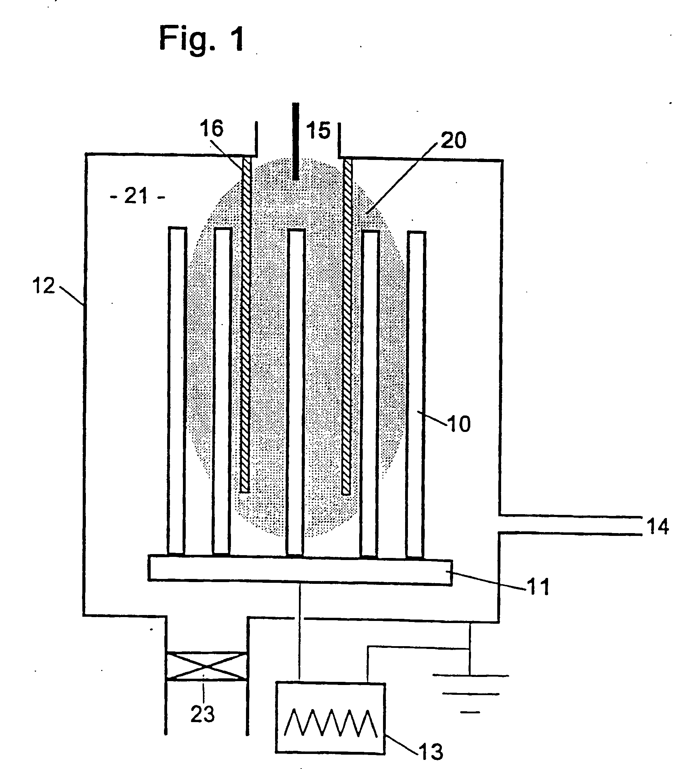

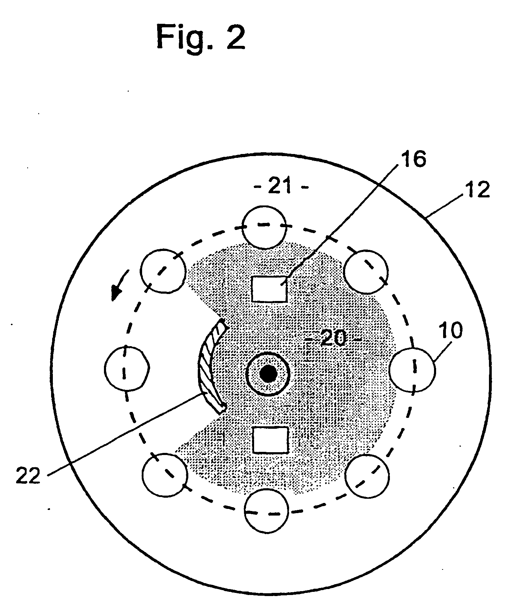

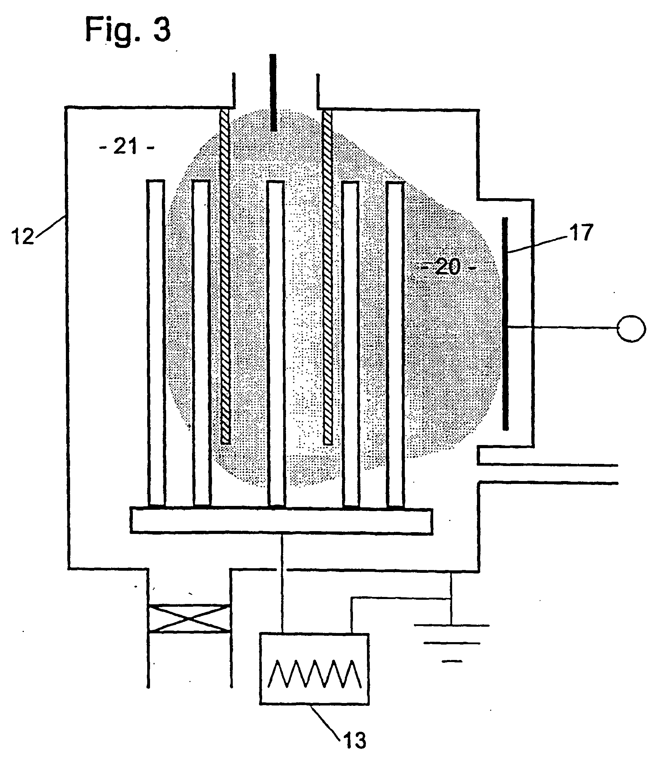

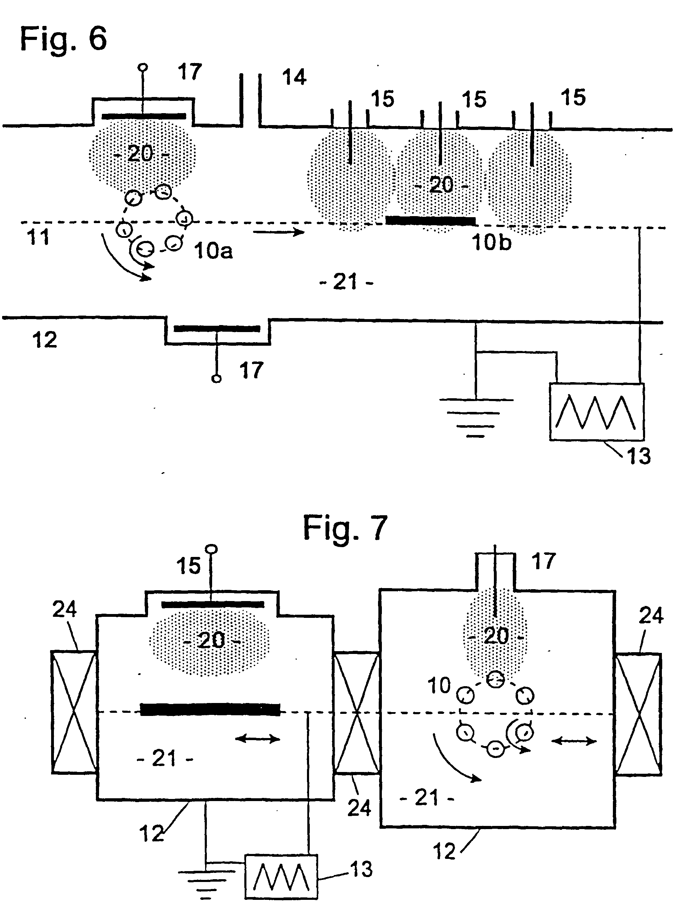

Es zeigen Figur 1 eine Einrichtung zur Plasma-CVD-Beschichtung von Substraten in Seitenansicht, Figur 2 dieselbe Einrichtung in Draufsicht, Figuren 3 bis 5 Varianten zu der in Figur 1 dargestellten Einrichtung, Figur 6 eine als Durchlaufanlage ausgeführte Einrichtung, Figur 7 eine Mehrkammereinrichtung.

### Beschreibung

Figur 1 zeigt eine Einrichtung zur Durchführung des vorgeschlagenen Verfahrens. Sie umfaßt einen Vakuumrezipienten 12, in dem eine Lagereinrichtung 11 angeordnet ist, auf der sich zu beschichtende Substrate 10 befinden. Die Substrate 10 sind elektrisch an eine außerhalb des Rezipienten 12 angeordnete Spannungsversorgung 13 gekoppelt. Die Lagereinrichtung 11 ist so ausgeführt, daß die Substrate 10 während der Beschichtung gleichförmig rotiert werden können, beispielsweise wie in Figur 1 angedeutet, in Form einer Drehscheibe. Es kann vorgesehen sein, die Substrate über entsprechende Vorrichtungen zusätzlich um weitere Drehachsen zu drehen. Als Spannungsversorgung 13 dient eine bipolare Gleichpulsquelle mit der Möglichkeit der zusätzlichen Überlagerung eines Gleichspannungspotentiales. Sie gestattet das Anlegen gepulster uni- oder bipolarer Gleichspannungspotentiale von bis zu mehreren kV mit Frequenzen von 0,1 kHz bis 10 Mhz, wobei Länge und Höhe der positiven und negativen Pulse getrennt voneinander einstellbar sind und spannungsfreie Pausenzeiten realisierbar sind. Der Vakuumrezipient 12 verfügt über ein Gaseinlassystem 14, über das Gase in seinen Innenraum eingebracht werden können. Des weiteren besitzt der Rezipient 12 ein Pumpensystem 23 zu seiner Evakuierung. Am Rezipienten 12 befindet sich weiter eine Mikrowellenquelle 15 zur Einkopplung von Mikrowellen in den Rezipienteninnenraum 21, wo sie ein Plasma 20 erzeugen. Sie ist beispielsweise als Quarzfenster mit mit Hohlleiterstrahler oder mit Antennenkonfigurationen ausgebildet. Im Rezipienteninnenraum 21 befinden sich Magnete 16, die wie in Figur 1 angedeutet als Magnetbänke ausgeführt sein können. Sie bewirken eine gleichmäßige Verteilung des mit Hilfe der Mikrowellenquelle 15 erzeugten Plasmas 20 im Rezipienteninnenraum 21 und sind entsprechend angeordnet.

Die Anordnung der Plasmaquelle 15 erfolgt entsprechend konstruktiven und prozeßtechnischen Randbedingungen. Sie kann hierzu, wie in Figur 1 angedeutet, mittig in Bezug auf die Lagereinrichtung 11, an einer Wandseite oder verteilt über den Rezipienten 12 erfolgen. Bei mittiger Anordnung ergibt sich ein im wesentlichen zentralsymmetrisches Plasma 20, das für eine gleichmäßige Beschichtung der nach innen weisenden Substratflächen sorgt, während die Beschichtungsrate der nach außen weisenden Flächen geringer ist und dort zur Abscheidung von Schichten anderer Qualität führt. Bei an einer Seitenwand des Rezipienten 12 angeordneter Plasmaquelle ergibt sich die umgekehrte Situation. Es können auch Plasmaquellen innen und außen kombiniert werden, um Schichten mit wieder anderer Qualität und anderen Eigenschaften zu erzeugen. Im Rezipienten 12 können weiterhin Blenden 22 vorgesehen sein, welche die Ausbildung eines Plasmas in einem Teil des Rezipienteninnenraums 21 verhindern. Dadurch lassen sich im Rezipienteninnenraum 21 unterschiedliche Beschichtungsbedingungen zur Herbeiführung unterschiedlicher Einzelschichten erzeugen. Die zu beschichtenden Substrate 10 werden dazu, wie in Figur 2 durch Pfeile angedeutet, durch die Teilvolumina des Rezipienteninnenraums 21 mit den unterschiedlichen Plasmabedingungen bewegt. In Folge ergeben sich damit steuerbare Eigenschaften der aufwachsenden, aus einzelnen oder zahlreichen Einzelschichten als Mehrfach- oder Multilagenschicht bestehenden Gesamtschicht.

Der Betrieb der in den Figuren 1 und 2 wiedergegebenen Anlage erfolgt, indem im Rezipienteninnenraum 21 nach Evakuierung mittels des Pumpensystems 23 auf einen Restdruck von typischerweise 10⁻⁴ mbar. Zweckmäßig werden die zu beschichtenden Substrate 21 sodann zunächst vorkonditioniert, z.B. durch Erwärmen, Reinigen durch Plasmaätzen und Vorbeschichten zur Haftungsverbesserung der nachfolgend aufgebrachten Schicht. Anschließend wird über das Gaseinlaßsystem 14 ein Gas in den Rezipienten 21 eingeleitet und mit Hilfe der Mikrowellenquelle 15 ein Plasma 20 erzeugt. Dabei entstehen besondere Plasmabedingungen, wenn die Gase durch die Plasmaquelle hindurch oder nahe der Plasmaquelle in den Rezipienten eingeleitet werden, beispielsweise ergibt sich eine räumlich erhöhte Plasmadichten und/oder ein erhöhter Gasumsatz. Als Gase eignen sich eine Reihe von Gasen und Gasgemischen. Reaktive Gase zur Aufbringung kohlenstoffhaltiger Schichten sind beispielsweise Kohlenwasserstoffe C_{X}H_{Y}, insbesondere C₂H₂ und CH₄ Zur Aufbringung siliciumhaltiger Schichten eignen sich Silane und Siloxane, insbesondere SiH₄ und HMDS, HMDS(O), HMDS(N), TEOS, TMS. Zur Erzeugung und Aufrechterhaltung des Plasmas 20 werden Edelgase, etwa Argon, Neon oder Helium eingesetzt. Bei Verwendung von Argon lassen sich durch Variation des Argon-Partialdruckes der Beschuß mit nichtschichtbildenden Ionen während der Schichtabscheidung, und darüber Härte und Eigenspannung der Schicht einstellen. Wird Helium verwendet, ist es möglich, den in die Schichten durch wasserstoffhaltige Gase eingebrachten Wasserstoffanteil zu beeinflussen und die Schichten zusätzlich zu verdichten. Wird Neon eingesetzt, kann eine gezielte Kompaktierung der Schichten erreicht werden. Werden metallorganische Verbindungen als reaktives Gas verwendet, kann über das reaktive Gas die Einbringung von Metallen in die Beschichtung erfolgen. Mit H₂ läßt sich der H-Gehalt der Schichten beeinflussen, mit N₂, NH₂ oder borhaltigen Gasen die Schichteigenschaften hinsichtlich Eigenspannungen und Benetzungsverhalten. Si-haltige Gase beeinflussen die Eigenspannungen und das Benetzungsverhalten von Kohlenstoffschichten, C-haltige Gase führen bei Siliciumschichten zu geringerer Reibung, zu Dotierung, elektrischer Leitfähigkeit und zur Abscheidung von a-SiC:H.

Unabhängig von der Erzeugung des Plasmas 20 wird an die zu beschichtenden Substrate 10 während der Beschichtung mit Hilfe der Spannungsversorgung 13 ein veränderliches Spannungspotential, die Substratspannung US angelegt. Sie dient zur Steuerung des Ionenbeschusses der Substrate 10 während der Beschichtung. Der positive Anteil der Substratspannung bewirkt bei elektrisch isolierenden Substratoberflächen eine Entladung der durch den vorangegangenen Ionenbeschuß aufgeladenen Oberfläche. Die Dauer der positiven Pulse ist hierfür kleiner oder gleich zu halten wie die Dauer der negativen Pulse. Soll die Temperaturbelastung der Substrate gering gehalten werden, ist die Spannungsamplitude der positiven Pulse deutlich geringer als die der negativen Pulse zu wählen.

Durch Variation der Zusammensetzung des zugeführten Gases und der Beschaffenheit der durch die Spannungsversorgung 13 erzeugten Substratspannung US lassen sich auf den Substraten 10 Schichtsysteme mit einer Vielzahl von Schichten mit jeweils unterschiedlichen Schichteigenschaften aufbauen. Herstellen lassen sich insbesondere harte, verschleißfeste, korrosionsbeständige und einen niedrigen Reibwert aufweisende Schichten. Die Haftung von Schichten, insbesondere harter Schichten oder von Schichten mit hohen mechanischen Eigenspannungen kann häufig durch Verwendung geeigneter Zwischenschichten weiter verbessert werden. Als besonders vorteilhaft hat sich die Ausbildung von Gradientenschichten erwiesen, die einen weichen Übergang bezüglich ihrer mechanischen Eigenschaften, insbesondere Härte und Elastizität zur Funktionsschicht hin ermöglichen. So wird die Haftung einer amorphen Kohlenstoffschicht auf einem Stahlsubstrat durch die Verwendung eines Zwischenschichtsystemes aus durch geeignete Prozeßführung gradiert ineinander überführten metallischen und modifizierten metallhaltigen Kohlenstoffschichten verbessert. In einfacher Weise lassen sich solche metallhaltigen Kohlenstoffschichten durch reaktives Sputtern von Metall aufbringen. Zur Aufrechterhaltung des Sputterprozesses ist dabei Argon (Ar) als weiteres Gas zuzuführen.

Alternativ können Haftschichtsysteme verwendet werden, die auf amorphen Silicium- oder Siliciumkohlenstoffschichten basieren. Als reaktive Gase zur Abscheidung solcher Schichten eignen sich Silane und Siloxane neben den entsprechenden kohlenstoffhaltigen Gasen.

Mit der in den Figuren 1 und 2 wiedergegebenen Anordnung konnte in einer ersten Anwendung eine 2 µm dicke amorphe Kohlenstoffschicht (a-C:H bzw. DLC) auf Stahl (100Cr6) und Silicium abgeschieden werden mit haftungsvermittelnder Zwischenschicht. Dabei wurden folgende Prozeßparameter eingestellt: reaktives Gas: Acetylen mit einem Durchfluß von 300 Standard-cm³/Min, Rezipientendruck: 3x10⁻³ mbar, Mikrowellenleistung: 1 kW, elektrische Leistung: 1 kW, Substratspannung: bipolar gepulst, positive Pulse: 10 µsek, negative Pulse: 10 µsek. Die erzeugte Schicht besaß eine Mikrohärte von 35 Gpa bei einem E-Modul von 165 GPa. Der Reibwert gegen Stahl (100Cr6) lag bei Raumbedingungen bei 0,12 im Trockenlauf. Eine solche Schicht eignet sich besonders als Verschleißschutzschicht. Durch Variation der elektrischen Leistung zwischen 200 W und 2 kW ließ sich die Schichthärte im Bereich von 10 GPa bis 42 GPa variieren. Bei Verkürzung des negativen Pulses ergaben sich härtere Schichten und eine höhere Abscheiderate bei allerdings steigender Substrattemperatur. Durch Einstellung von spannungsfreien Pausenzeiten nach jedem Puls ist es, bei Reduktion der Beschichtungsrate und Schichthärte möglich, die Beschichtungstemperatur abzusenken. Vorteilhaft kann es sein, die Pausenzeit nach negativem Puls kleiner als nach positivem Puls zu wählen. Durch Vorreinigung der Substrate 10 außerhalb der Anlage nach einem üblichen Verfahren konnte die Schichthaftung weiter verbessert werden. Die Schichabscheidungsrate ließ sich durch Variation der Mikrowellenleistung zwischen 0,6 kW und 1,1 kW sowie des Acetylengasflusses zwischen 100 und 450 Standard-cm³/Min steuern. Als vorteilhaft erwies sich zudem eine Plasmafeinreinigung nach einem bekannten Verfahren nach Einbringen der Substrate 10 in den Rezipienten 12 und Evakuierung. Durch Einbringen eines siliciumhaltigen reaktiven Gases zu Beginn des Beschichtungsvorganges zwecks Abscheidung einer haftvermittelnden Schicht ließ sich die Schichthaftung weiter verbessern.

Die Eigenschaften von amorphen Kohlenstoffschichten lassen sich etwa über den Wasserstoffgehalt oder über eine Dotierung bezüglich ihrer optischen und elektrischen Eigenschaften über ein breites Spektrum von Absortion und schwarzer Farbe bis zu Transparenz bzw. von Leitfähigkeit bis zu isolierender Wirkung einstellen. Die Schichten eignen sich dadurch für Anwendungen mit optischen und elektrischen Anforderungen, beispielsweise als elektrisch isolierende Schicht, als transparente Kratzschutzschicht, als dekorative verschleißfeste Schicht oder als Black-Matrix-Schicht im Display.

In einer weiteren Anwendung der in den Figuren 1 und 2 wiedergegebenen Anordnung konnte eine metallfreie amorphe Kohlenstoffschicht von 2,5 µm Dicke auf ein Stahl(100Cr6)-Substrat als Korrosionsschutz aufgebracht werden. Vor Einbringen der Substrate in den Rezipienten erfolgte hier eine Reinigung der Anlage, um lose Partikel zu entfernen und das Abplatzen von aus vorherigen Beschichtungszyklen vorhandenen Schichten zu vermeiden und so einen porenfreien Schichtaufbau zu gewährleisten. Die Prozeßparameter wurden wie im vorhergehenden Beispiel gewählt, jedoch wurde ein geringerer Arbeitsdruck von 1-2x10⁻³ mbar eingestellt, um den Effekt der Partikelbildung zu verringern.

In einer weiteren Anwendung eignet sich die in den Figuren 1 und 2 wiedergegebene Anlage zur Erzeugung von aus einer Vielzahl dünner Einzelschichten unterschiedlicher Härte und unterschiedlichen Spannungszustandes aufgebauten Multilagenschichten. Solche Multilagenschichten zeichnen sich durch besonders geringe Eigenspannungen bei großer Härte aus. Anwendbar ist diese Technik u. a. bei amorphen Kohlenstoff- und Siliciumschichten. Der Multilagenaufbau aus Einzelschichten wird durch periodische Variation der Substratspannung realisiert. Bei Verringerung der Substratspannung werden weichere Schichten erzeugt, bei Erhöhung härtere. Die Schichtstruktur kann von graphitischen Schichten, entsprechend einer Substratspannung von 0 Volt, bis zu Schichten mit Härten von über 50 GPa variiert werden. Die Dauer der einzelnen Pulse der Substratspannung wird dabei so an die Schichtwachstumsrate angepaßt, daß Einzelschichten zwischen 1 nm und 2 µm, bevorzugt 5 nm bis 200 nm abgeschieden werden. Der Übergang zwischen den Einzelschichten wird durch abrupte Änderung der Substratspannung bewirkt. Alternativ kann die Variation der Substratspannung langsam erfolgen, so daß ein kontinuierlicher Übergang zwischen den Einzelschichten entsteht. Vorgesehen sein kann eine Prozeßparametersteuerung derart, daß der entstehende Multilagenverband aus einer Vielzahl verschiedenartiger Einzelschichten besteht.

Zur Unterstützung der unterschiedlichen Ausgestaltung der Einzelschichten kann zusätzlich zur Substratspannung eine Variation der über die Mikrowellenquelle 15 eingekoppelten Mikrowellenleistung oder der Menge des zugeführten Gases vorgesehen sein. Beides bewirkt eine Variation der Plasmadichte sowie des Arbeitsdruckes und damit der Ionenenergieverteilung, was für die jeweils gewünschten Schichteigenschaften gezielt einzustellen ist.

Eine Variation der Prozeßparameter zur Erzeugung eines Multilagenverbandes aus vielen Einzelschichten kann auch durch Gliederung des Rezipienteninnenraumes 21 in Teilvolumina mit unterschiedlichen Plasmadichten bewirkt werden, indem die zu beschichtenden Substrate 10 nacheinander periodisch durch die verschiedenen Teilvolumina bewegt werden. Erreichen läßt sich eine solche Rezipienteninnenraumgliederung beispielsweise, wie in Figur 2 angedeutet, durch Blenden 22, welche die Ausbildung des Plasmas 20 in einem Teil des Rezipienteninnenraums 21 verhindern. Bei rotatorischer Bewegung der Substrate etwa durch Drehung einer als Drehscheibe ausgebildeten Lagereinrichtung 11 läßt sich die Dicke der Einzelschichten über die Rotationsfrequenz der Substrate durch die Teilvolumina steuern.

Eine Gliederung des Rezipienteninneraumes 21 in Teilvolumina läßt sich alternativ auch durch gleichzeitige Nutzung unterschiedlicher, an verschiedenen Stellen des Rezipienten 12 plazierter Plasmaquellen wie Mikrowellenquelle(n) und Hohlkathode(n) oder unterschiedlicher Mikrowellenquellen herbeiführen.

In einer weiteren Ausführungsvariante wird als weichere von zwei Einzelschichten eine modifizierte metallhaltige Kohlenstoffschicht gewählt. Die Aufbringung der Teilschichten erfolgt in bekannter Weise durch reaktives Magnetonsputtern. Eine hierzu geeignete, modifizierte Anordnung zeigt Figur 3. Sie unterscheidet sich von einer Anordnung gemäß Figuren 1 und 2 durch eine zusätzliche Magnetronsputterquelle 17, welche wie in der Figur angedeutet, seitlich in der Rezipientenwand angeordnet sein kann. Die Anlage gestattet durch Steuerung des Rücksputterns von den Substraten 10 über die angelegte Substratspannung eine gezielte Beeinflussung des in die entstehenden Schichten eingebauten Metallanteils.

Eine weitere Anwendung sieht die Verwendung derselben Prozeßparameter wie im ersten Anwendungsbeispiel vor, als zusätzliches reaktives Gas wird jedoch Silan oder Siloxan mit 20 Standard-cm³/min zugeführt. Das Silan bzw. Si-haltige Gas als zusätzliches reaktives Gas führt zu einem Einbau von einigen Atomprozent Silicium in die abgeschiedene Schicht. Es bewirkt eine Verminderung von Schichteigenspannungen und beeinflußt das Benetzungsverhalten bezüglich verschiedener Flüssigkeiten. Auf diese Weise läßt sich insbesondere das Verhalten eines beschichteten Substrates im tribologischen Kontakt steuern. In einer Variante dieser Anwendung wird der Gasfluß der Si-haltigen Gase größer gewählt als der des Acetylens. Dadurch wird eine wasserstoffhaltige Siliciumschicht mit Kohlenstoff als zusätzlichem Bestandteil abgeschieden. Zur Erhöhung der Haftung auf Glas und metallischen Substraten wie Stahl (100Cr6) hat sich das Aufbringen einer modifizierten Siliciurn-Haftschicht bewährt.

In einer weiteren Variante ist der Anteil des Acetylens im reaktiven Gas zu Null gewählt, so daß eine amorphe, wasserstoffhaltige Siliciumschicht (a-Si:H) abgeschieden wird. Eine solche Schicht eignet sich als Verschleißschutzschicht. Sie kann weiter modifiziert werden. So kann durch Zugabe einer entsprechenden Komponente eine stöchiometrische Verbindung abgeschieden werden. Ein Beispiel dafür ist die Abscheidung von wasserstoffhaltigem Siliciumnitrid (SiN) durch Zugabe von Stickstoff zum reaktiven Gas. Die entstehende Schicht zeichnet sich durch hohe Verschleißbeständigkeit und elektrische Isolationswirkung aus. Analog lassen sich des weiteren Schichten für andere Anwendungen erzeugen, beispielsweise Schichten für den Aufbau von elektrischen Halbleiterelementen. Die erforderlichen elektrischen Eigenschaften können über die Prozeßparameter eingestellt werden, etwa über den Wasserstoffgehalt und eine Dotierung. Eine Isolationswirkung wird durch Abscheidung einer isolierenden Verbindung erreicht. Geeignet sind solche Schichten beispielsweise für die Herstellung von Solarzellen oder Flat Panel Displays, bei denen besonders die Möglichkeit zur großflächigen Abscheidung einen großen Vorteil bietet.

Die transparente, kratzfeste oder auch elektrisch leitfähige Beschichtung von Glas, Solarzellen und Displays stellt ein weiteres Anwdungsgebiet dieser Schichten dar.

Statt Acetylen, das den Vorteil hat, daß damit häufig höhere Abscheideraten realisiert werden können als mit anderen kohlenwasserstoffhaltigen reaktiven Gasen, können in den vorstehend genannten Ausführungsbeispielen auch andere kohlenstoffhaltige reaktive Gase eingesetzt werden. Dazu sind die Prozeßparameter an die geänderten Bedingungen anzupassen.

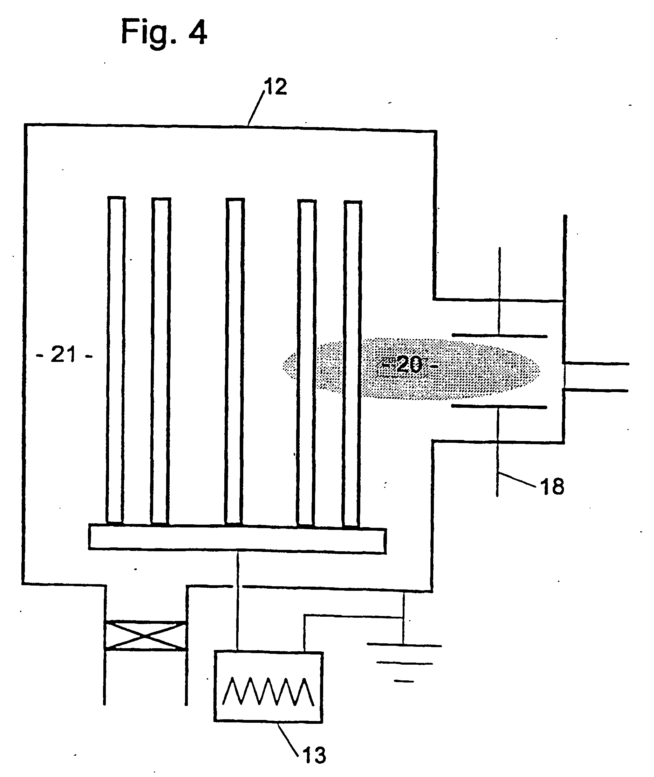

Figur 4 zeigt eine modifizierte Anordnung zur Durchführung des vorgeschlagenen Verfahrens. Sie unterscheidet sich von der in den Figuren 1 und 2 wiedergegebenen Anordnung hinsichtlich der Mittel zur Erzeugung des Beschichtungsplasmas 20. Als Plasmaquelle dient jetzt eine Hohlkathode 18, welche seitlich am Rezipienten 12 angeordnet und als Hohlzylinder geformt ist. Das Gas wird durch die zylindrische Hohlkathode 18 in den Rezipienteninnenraum 21 eingebracht. Vorteil der Anordnung ist der hohe Anregungsgrad und damit die hohe Effektivität der Plasmaerzeugung. In einer abgewandelten Ausführung besteht die Hohlkathode 18 aus zwei zueinander parallelen Platten, die in ihrer Länge an die Größe des Rezipienten 12 angepaßt sind. Bei Verwendung von Acetylen als reaktivem Gas können mit einer solchen Anordnung diamantartige Kohlenstoffschichten mit Raten deutlich größer als 5 µm/h auf bewegte Substrate 10 in industriell üblichen Chargengrößen abgeschieden werden. Bei Erhöhung des Gasdruckes kann zur Vermeidung von Partikelbildung der Einsatz von CH₄ oder Mischungen unterschiedlicher kohlenwasserstoffhaltiger reaktiver Gase sinnvoll sein. Die Einstellung der Schichteigenschaften erfolgt wiederum über Variation der Substratspannung über die Spannungsversorgung 13. Bei Einbau von Metallatomen, die von der Hohlkathode 18 abgetragen werden, ist die auf den Substraten erzeugte Schicht in Abhängigkeit von den Prozeßparametern un der Konzentration der eingebauten Metallatome elektrisch leitfähig. In diesem Fall kann an die Substrate 10 an Stelle einer Wechselspannung eine Gleichspannung angelegt werden. Zur Reduktion der Beschichtungstemperatur und zur besseren Steuerung der Schichteigenschaften bietet es sich auch hier der Einsatz einer gepulsten Bias-Spannungsquelle an.

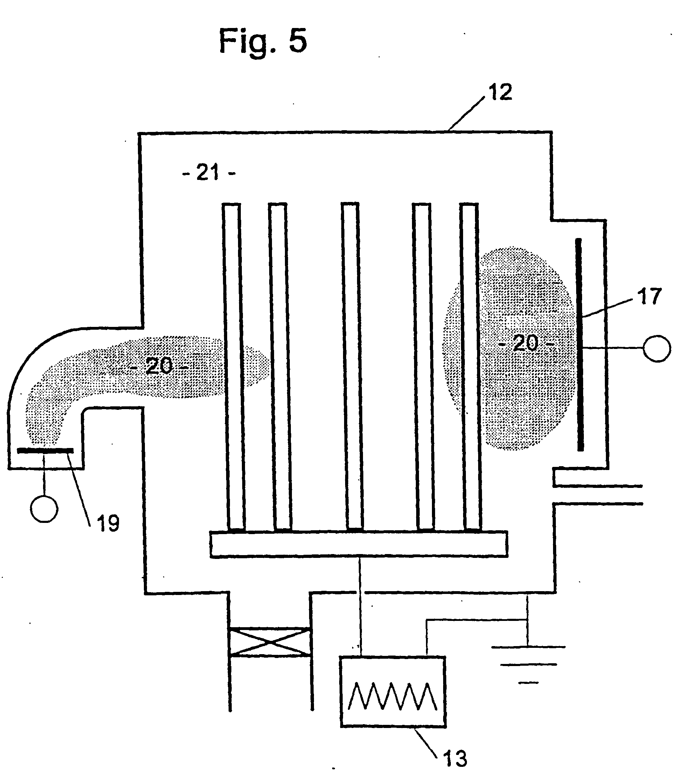

Eine weitere modifizierte, insbesondere zur Abscheidung von Kohlenstoffschichten geeignete Anordnung zur Durchführung des Verfahrens zeigt Figur 5. Sie unterscheidet sich von der in Figur 1 und 2 wiedergegebenen Anordnung wiederum hinsichtlich der Mittel zur Erzeugung des Plasmas 20. Die Plasmaerzeugung erfolgt hier durch einen Hochstrombogen, welcher zwischen einem in der Seitenwand des Rezipienten 12 angeordneten Kohlenstoff target 19 und einer - nicht gezeigten - Anode gezündet wird, und durch eine in der gegenüberliegenden Seitenwand angeordnete Sputterkathode 17. Vorteil des Hochstrombogens ist der hohe Ionisierungsgrad des freigesetzten Kohlenstoffs. Da zur Einbringung des Kohlenstoffs keine wasserstoffhaltigen Gase erforderlich sind, ist die resultierende, auf den Substraten 10 abgeschiedene Schicht wasserstoffrei und dadurch besonders temperaturbeständig. Solche wasserstoffreien Kohlenstoffschichten weisen eine Härte von bis zu 80 GPa auf. Bei der in Figur 5 angedeuteten Anordnungsausführung werden bei der Bogenverdampfung entstehende graphitische Makroparitikel ebenfalls auf den Substraten 10 abgeschieden. Der Effekt kann erwünscht sein, da sich die Makropartikel beispielsweise als in der Schicht eingebaute Schmierstoffdepots eignen. Durch Pulsen des Bogenstromes läßt sich die Makropartikelbildung andererseits unterdrücken, wobei eine gleichzeitige Erhöhung des Bogenstroms die Unterdrückung verstärkt. Eine nahezu vollständige Unterdrückung von Makropartikeln läßt sich erreichen, indem die durch die Bogenverdampfung erzeugten Ionen magnetisch auf die Substrate 10 umgelenkt werden. Die ungeladenen Makropartikel treffen auf eine Prallplatte und werden von der Schichtabscheidung ferngehalten.

Die Lagereinrichtung kann alternativ so beschaffen sein, daß die Substrate während der Beschichtung unbewegt sind. Das kann beispielsweise aufgrund erhöhter Abscheideraten oder erzielbarer Schichteigenschaften vorteilhaft sein. Die Substrate können weiterhin auch getaktet bewegt werden, so daß sie sich zu verschiedenen Zeiten in verschiedenen räumlichen Bereichen des Rezipienten dort jeweils unbewegt befinden.

In einer weiteren Anwendung kann die Beschichtung auch in einer Einrichtung durchgeführt werden, die Teil eines größeren Verbundes von Einrichtungen ist. Die Substrate werden dabei von Einrichtung zu Einrichtung mit oder ohne Unterbrechung des Vakuums bewegt, wobei in jeder einzelnen Einrichtung ein oder mehrere Behandlungsschritte vollzogen werden. Figur 6 zeigt als Beispiel dafür eine lineare Anordnung von Einrichtungen in Form einer Durchlaufanlage. Die drehend oder fest gelagerten Substrate 10a, 10b werden dabei durch einen geeigneten, durch einen Pfeil angedeuteten b Lineartranslator durch die verschiedenen Einrichtungen, etwa wie in Figur 6 gezeigt eine Magnetronsputterquelle 17 und drei Mikrowellenquellen 15, und erfahren in jeder Einrichtung 17, 15 entsprechende Behandlungs- oder Beschichtungsschritte. Sequentiell aufeinanderfolgen können so beispielsweise: Plasmaätzen, Haftschichtabscheidung und Hauptschichtabscheidung. Dabei können die Substrate bewegt, unbewegt, oder getaktet bewegt behandelt werden. In Abhängigkeit von Substrat, Einrichtung und Prozeß kann eine Behandlung von liegenden oder stehenden Substraten erfolgen. So ist etwa für die Behandlung von Folien oder Glas eine liegende Anordnung der Substrate möglich.

Figur 7 zeigt als weiteres Beispiel für einen Einrichtungsverbund eine Mehrkammeranlage mit mit zwei, über vakuumdichte Schleusentüren 24 verbundenen Rezipienten 12, zwischen denen zu beschichtende Substrate 10 hin und her transportiert werden können. Im Beispiel Figur 7 befindet sich in einem Reziepienten eine Mikrowellenquelle 15, im anderen eine Magnetronsputterquelle 17.

Zur Plasmabeschichtung von Schüttgut kann die Substrathalterung desweiteren auch als Drehkorb ausgebildet sein, der sich langsam um eine Plasmaquelle herumbewegt.

In vorteilhafter Weise läßt sich die erfindungsgemäße Einrichtung zur Herstellung einer Multilagenstruktur aus alternierenden Einzelschichten einsetzten. Multilagenstrukturen können im Vergleich zu Einzelschichten gleicher Dicke mit niedrigerer Eigenspannung abgeschieden werden. Dies reduziert die Neigung zu Schichtenthaftungen.

Aufgrund ihrer hervorragenden Wirkung als Korrosions- und Verschleißschutz für tribologisch hochbelatete Bauteile sind Ausführungen der o.g. Multilagenstrukturen besonders vorteilhaft, welche aus alternierenden Hartstoff-und Kohlenstoffeinzelschichten bestehen. Entsprechend der vorgesehenen Anwendung werden dabei bezüglich der Zusammensetzung - bevorzugt - jeweils eine Art der Hartstoffschicht und eine Art der Kohlenstoffschicht kombiniert, die je aus einer Vielzahl von Vertretern der beiden Schichttypen ausgewählt werden.

Bei der Herstellung der Schichten der genannten Multilagenstruktur wird im Prinzip in derselben Weise vorgegangen wie bei der Herstellung von Einzelschichten. Ein Unterschied im Verfahren ergibt sich jedoch dadurch, daß aufeinanderfolgend alternierende Schichten aufgebracht werden müssen. Die Proben werden vorgereinigt und in einen Rezipienten gebracht, wie er vereinfacht in der Fig. 3 gezeigt ist. Dieser wird auf einen Druck von weniger als etwa 1x10⁻⁴ mbar evakuiert. Anschließend werden die Proben im Plasma feingereinigt, etwa durch Plasmaglimmen. Dann werden die Schichten aufgebracht. Damit alternierende Schichten erzeugt werden, werden die Proben beispielsweise mittels Planetengetrieben bewegt und dadurch cyclisch an unterschiedlichen Quellen vorbeigeführt. Durch die Bewegung der Proben relativ zu den Quellen wird auch die Abscheidung homogener Schichten auf komplex geformten Proben erleichtert. Zur Durchführung des Verfahrens sind die anhand der Figuren 1 bis 7 veranschaulichten Einrichtungen einsetzbar. Dabei können die Quellen beliebig angeordnet sein, etwa - wie die Sputterkathode in der Fig. 3 - an der Rezipientenwand oder im Innern des Rezipienten. Falls erforderlich können - beispielweise - die in den Figuren 3 und 5 gezeigten Einrichtungen noch modifiziert werden, etwa durch den Einbau einer zusätzlichen Sputterkathode (s.u.).

Während der Vorbeiführung an einer ersten Quelle wird eine erste Schicht auf der Probe deponiert. Die Schichtdicke hängt von der Beschichtungsrate der Quelle und der Geschwindigkeit der Probe ab. Dann wird die Probe an einer zweiten Quelle vorbeigeführt, und dabei eine zweite Schicht aufgebracht. Daraufhin wird die Probe wieder an der ersten Quelle vorbeigeführt und beschichtet usw. Durch diese Bewegung relativ zu unterschiedlichen Quellen und die dabei durchgeführte cyclische Beschichtung wird bei geeigneter Wahl der Beschichtungsrate und der Geschwindigkeit der Probe die gewünschte Multilagenstruktur abgeschieden.

Die Betriebsparameter sind abhängig von den verwendeten Quellen. Sputterkathoden werden insbesondere in einem Druckbereich von 1-3x10⁻³ mbar betrieben, der durch Einlaß von Ar oder eines anderen Edelgases eingestellt wird. Die Hartstoffschichten werden bevorzugt durch Sputtern von wie die gewünschte Schicht zusammengestzten Sputtertargets oder durch reaktives Sputtern erzeugt. Alternativ zum Sputtern kann die Verdampfung im Lichtbogen (Arc) bei der Abscheidung angewandt werden.Als Kohlenstoffspender für die Hartstoffschicht wie auch für die Kohlenstoffschichten werden insbesondere kohlenstoffhaltige Gase, wie Acetylen oder Methan, aber auch Graphittargets, aus Metallcarbid bestehende Targets und Lichtbögen, als stickstoffspender besonders stickstoffhaltige Gase, wie Stickstoff und Ammoniak und aus Metallnitrid bestehende Targets und als Siliciumspender Silane und Siloxane und aus Metallsilicid bestehende Targets eingesetzt. Die Leistung, mit der die Kathoden betrieben werden, liegt bevorzugt zwischen 2kW und 20 kW pro Kathode. Durch Leistungsregelung kann die Beschichtungsrate eingestellt werden, was von Bedeutung ist, weil die Quellen aus unterschiedlichen Materialien bestehen, und eine Multilagenstruktur angestrebt wird, in der die Einzelschichten etwa gleiche Schichtdicken aufweisen.

Alternativ kann die Multilagenstruktur auch aus alternierenden Hartstoff- und Siliciumeinzelschichten aufgebaut sein. Die Struktur, bei der die Siliciumschicht die oben angeführten Zusammensetzungen haben kann, hat die ebenfalls oben angeführten Vorteile. Bei der Herstellung sind - bezüglich der Targets und der reaktiven Gase entsprechend angepaßt - dieselben Verfahren und Einrichtungen anwendbar wie bei den aus alternierenden Hartstoff- und Kohlenstoffeinzelschichten bestehenden Strukturen.

Im folgenden werden sieben Ausführungsbeispiele der erfindungsgemäßen Multilagenstruktur beschrieben, die aus alternierenden Hartstoff- und Kohlenstoffschichten aufgebaut sind, wobei die beiden Schichtarten aus jeweils einem Material gebildet werden.

### Beispiel 1

Die Multilagenstruktur besteht aus Metallcarbid (MeC) und metallhaltigem Kohlenstoff (C-(MeC)). Vorteilhafte Metalle sind u.a. Wolfram (W), Chrom (Cr). Die Dicken der Einzelschichten liegen zwischen etwa 3 und etwa 5 nm und die Gesamtschichtdicke liegt zwischen etwa 2 und 3 µm. Das Multilagensystem ist auf einem Stahl- oder Hartmetallsubstrat, wie einem Bauteil oder einem Werkzeug, aufgebracht.

Die Herstellung der Struktur erfolgt durch reaktives Sputtern von Targets einerseits aus Metallen (Me) und andererseits aus Metallcarbiden (MeC) in einer Atmosphäre, die aus einer Mischung aus Edelgas, wie Argon, als Sputtergas und einem kohlenstoffhaltigem Gas, wie Acetylen und Methan, als reaktivem Gas besteht. Die Schichten können mit einer Einrichtung abgeschieden werden, die sich von der in der Fig. 3 dargestellten durch eine zusätzliche Sputterkathode unterscheidet. Der Gasfluß wird in bekannter Weise so konstant eingestellt, daß im einen Verfahrensschritt vom Metalltarget MeC und im nächsten Schritt vom MeC-Target C-(MeC) gesputtert wird und im übernächsten wieder vom Metalltarget MeC usw., bis die erforderliche Gesamtschichtdicke erreicht ist.

### Beispiel 2

Das Multilagensystems besteht aus C-(MeC) als Hartstoff, wobei das Metall bevorzugt Wolfram ist, und aus metallfreiem amorphem wasserstofhaltigem Kohlenstoff (a-C:H). Die Schichtdicken liegen in denselben Bereichen wie beim ersten Ausführungsbeispiel. Die C-(MeC)-Schicht wird mittels reaktiven Sputterns - beispielsweise - eines WC-Targets erzeugt, wobei der zusätzliche Kohlenstoff von Acetylen oder Methan geliefert wird. Die a-C:H-Schicht erhält man mittels einer der oben beschriebenen Plasmaquellen, wie einer RF-Quelle, einer MW-Quelle (s. Figur 3) oder einer Hohlkathodenquelle (s. Figur 4) in der Acetylen oder Methan enthaltenden Atmosphäre. Die Abscheidung der Multilagenstruktur kann mit der in der Figur 3 gezeigten Einrichtung oder mit einer Einrichtung durchgeführt werden, die sich von der in der Fig. 4 gezeigten durch eine zusätzliche Sputterkathode unterscheidet.

### Beispiel 3

Das Multilagensystem besteht aus einem Metall (Me) als Hartstoff und a-C:H. Das Metall ist bevorzugt aus den im Beispiel 1 genannten ausgewählt. Die Schichtdicken liegen in denselben Bereichen wie beim ersten Ausführungsbeispiel. Zum Aufbringen der Schichten werden zwei voneinander getrennte Gasräume benötigt, damit das Metall durch Sputtern oder Aufdampfen von Metall in einer nicht kohlenstoffhaltigen Atmosphäre und a-C:H in einer Methan oder Acetylen enthaltende Atmosphäre aufgebracht werden kann. Die Herstellung der Multilagenstruktur läßt sich mit Einrichtungen durchführen, die ähnlich den in den Figuren 6 und 7 gezeigten arbeiten, wobei eine Trennung der Gasräume auch - obwohl nicht gezeigt - bei der in der Figur 6 gezeigten Einrichtung möglich ist. Damit nicht für jede Schicht ein Vielzahl von Quellen erforderlich ist, sind Ausbildungen der Einrichtungen vorteilhaft, bei denen die Proben nach dem Aufbringen der ersten zwei Schichten wieder an den Anfang der Einrichtung zurückgeführt und dann das Aufbringen weiterer zwei Schichten wiederholt wird, usw.

### Beispiel 4

In dem Multilagensystem bestehen die alternierenden Schichten aus einem Metallcarbid (MeC) als Hartstoff und a-C:H. Die Metalle sind bevorzugt aus den im Beispiel 1 genannten ausgewählt. Die Schichtdicken liegen in denselben Bereichen wie beim ersten Ausführungsbeispiel. Die MeC-Schicht wird durch reaktives Sputtern von einem aus dem Me bestehenden Target in einer Acetylen enthaltenden Atmosphäre abgeschieden. Die a-C:H-Schicht erhält man mittels einer der oben beschriebenen Plasmaquellen, wie einer RF-Quelle, einer MW-Quelle (s.Figur 3) oder einer Hohlkathodenquelle (s. Figur 4) in der Acetylen enthaltenden Atmosphäre. Die Abscheidung der Multilagenstruktur kann mit der in der Figur 3 gezeigten Einrichtung oder mit einer Einrichtung erzeugt werden, die sich von der in der Fig.4 gezeigten durch eine zusätzliche Sputterkathode unterscheidet.

### Beispiel 5

Das Multilagensystem besteht aus einem Metallnitrid (MeN) als Hartstoff, wobei das Metall bevorzugt Chrom ist, und aus a-C:H. Die Schichtdicken liegen in denselben Bereichen wie beim ersten Ausführungsbeispiel. Die Abscheidung der MeN-Schicht wird erreicht entweder durch Sputtern von einem MeN-Target oder durch reaktives Sputtern von einem Me-Target, wobei ein stickstoffhaltiges Gas als reaktives Gas eingesetzt wird und die Atmosphäre von der kohlenstofhaltigen Atmosphäre getrennt ist, in der die a-C:H-Schicht abgeschieden wird. Die Herstellung der Multilagenstruktur läßt sich - wie beim Beispiel 3 - mit Einrichtungen durchführen, die ähnlich den in den Figuren 6 und 7 gezeigten arbeiten. Wegen der Einzelheiten wird auf Beispiel 3 verwiesen.

### Beispiel 6

Das Multilagensystem besteht aus einem Metallcarbonitrid (MeCN) als Hartstoff, wobei das Metall bevorzugt Chrom ist, und aus a-C:H. Zur Erzeugung der MeCN-Schicht gibt es insbesondere zwei Alternativen: Reaktives Sputtern von einem Me-Target, wobei das reaktive Gas aus einem stickstoffhaltigen und einem kohlenstoffhaltigen Gas gemischt ist und reaktives Sputtern von einem MeN-Target wobei ein kohlenstoffhaltiges Gas als reaktives Gas eingesetzt wird. Zur Abscheidung der a-C:H-Schicht wird ein kohlenstoffhaltiges Gas eingesetzt. Als solches kann das bei der zweiten Alternative beim reaktiven Sputtern eingesetzte reaktive Gas mitverwendet werden, während bei der ersten Alternative die Abscheidung der a-C:H-Schicht in einem von der Sputteratmosphäre getrennten Gasraum erfolgt, der ein kohlenstoffhaltiges, aber stickstoffreies reaktives Gas enthält. Die Abscheidung entsprechend der ersten Alternative läßt sich - wie beim Beispiel 3 - mit Einrichtungen durchführen, die ähnlich den in den Figuren 6 und 7 gezeigten arbeiten, wobei wegen der Einzelheiten auf Beispiel 3 verwiesen wird. Die Abscheidung entsprechend der zweiten Alternative läßt sich mit der in der Figur 3 gezeigten Einrichtung durchführen.

### Beispiel 7

Bei Varianten der in den Beispielen 3, 4, 5 und 6 beschriebenen Multilagenstrukturen besteht die Kohlenstoffschicht statt aus a-C:H aus a-C. Die Hartstoffschicht wird bevorzugt von einem Target gesputtert, das je nach der gewünschten Zusammensetzung der Hartstoffschicht aus Me, MeC, MeN bzw. MeCN besteht, und die a-C-Schicht wird von einem Graphittarget gesputtet bzw. mittels eines Kohlebogens erzeugt. Die Multilagenstruktur läßt sich, je nachdem wie die a-C-Schicht erzeugt wird, mittels der in der Figur 5 gezeigten Einrichtung oder mittels einer Einrichtung abscheiden, die sich von der in der Figur 5 gezeigten dadurch unterscheidet, daß statt des Kohlenstofftargets 19 ein Graphittarget vorgesehen ist.

Durch entsprechende Wahl der Herstellbedingungen, wie der Sputtertargets und der reaktiven Gase, lassen sich die obengenannten Beispiele so abwandeln, daß statt der Kohlenstoffschichten entsprechende Siliciumschichten erzeugt und gegebenenfalls der Kohlenstoff in der Hartstoffschicht durch SIlicium ersetzt wird. So lassen sich beispielsweise aus alternierenden Me- und a-Si:H-Einzelschichten oder aus alternierenden MeSi- und a-Si:H- bestehenden Multilagenstrukturen erzeugen, wie es im Beispiel 3 bzw. 4 beschrieben ist.

Es sind auch andere Schichtkombinationen vorteilhaft einsetzbar, beispielsweise solche, bei denen die Hartstoffschichten und ebenso die Kohlenstoff- bzw. Siliciumschichten nicht alle aus demselben Material bestehen und/oder bei denen eine Kohlenstoffschicht, mit einer Silicium oder Silicium und Kohlenstoff enthaltenden Hartstoffschicht oder eine Siliciumschicht mit einer Kohlenstoff oder Kohlenstoff und Silicium enthaltenden Hartstoffschicht kombiniert ist.

## Patentansprüche

1. Verfahren zum Vakuumbeschichten eines Substrates mit einem Plasma-CVD-Verfahren, wobei an das Substrat zur Steuerung eines Ionenbeschusses während der Beschichtung eine Substratspannung angelegt ist und die Substratspannung (US) und das Beschichtungsplasma (20) unabhängig voneinander erzeugt werden und die Substratspannung (US) während der Beschichtung verändert wird, **dadurch gekennzeichnet, dass** als Substratspannung (US) eine bipolar gepulste Gleichspannung eingesetzt wird, deren positive und negative Pulse in zeitlicher Länge und/oder Höhe unabhängig voneinander eingestellt werden.

2. Verfahren nach Anspruch 1, **dadurch gekennzeichnet, dass** die Substratspannung (US) eine bipolar gepulste Gleichspannung mit einer Frequenz von 0,1 kHz bis 10 MHz, insbesondere 1 kHz bis 100 kHz, ist.

3. Verfahren nach Anspruch 1, **dadurch gekennzeichnet, dass** der Substratspannung (US) eine Gleichspannung überlagert wird.

4. Verfahren nach Anspruch 1, **dadurch gekennzeichnet, dass** zwischen den negativen und positiven Pulsen der Substratspannung (US) spannungslose Pausenzeiten von 0 bis 1 ms, insbesondere 2 bis 100 µs, vorgesehen sind.

5. Verfahren nach Anspruch 4, **dadurch gekennzeichnet, dass** die Pausenzeit nach einem negativen Puls kürzer ist als die Pausenzeit nach einem positiven Puls.

6. Verfahren nach Anspruch 1, **dadurch gekennzeichnet, dass** während der Beschichtung Gase unterschiedlicher Art und in verschiedenen Kombinationen zugesetzt werden.

7. Verfahren nach Anspruch 6, **dadurch gekennzeichnet, dass** die zugesetzten Gase durch die Plasmaquelle (18) hindurchgeleitet oder nahe an der Quelle eingeleitet werden.

8. Verfahren nach Anspruch 6, **dadurch gekennzeichnet, dass** als reaktives Gas CₓH_{y}, insbesondere C₂H₂ oder CH₄, Silane, Siloxane, insbesondere SiH₄ oder HMDS und dessen Derivate, Edelgase, metallorganische Verbindungen oder eine Kombination dieser Gase verwendet wird.

9. Plasma-CVD-Einrichtung zum Vakuumbeschichten eines Substrates (10) mit einem Vakuumrezipienten (12), einer Lagereinrichtung (11) zur Aufnahme der zu beschichtenden Substrate (10), Mitteln (15, 17, 18, 19) zur Erzeugung eines Plasmas (20) im Innenraum (21) des Rezipienten und einer von den Plasmaerzeugungsmitteln (15, 17, 18, 19) getrennt steuerbaren Einrichtung (13) zur Erzeugung einer Substratspannung (US), welche an die zu beschichtenden Substrate (10) angelegt ist, **dadurch gekennzeichnet, dass** die Einrichtung (13) ein bipolar pulsbares Gleichspannungsnetzteil mit getrennt voneinander einstellbaren Längen und/oder Höhen der positiven und negativen Pulse ist, und dass das Mittel (15, 17, 18, 19) zur Erzeugung des Plasmas (20) eine Mikrowellenquelle (15), eine Sputterkathode (17), eine Anordnung zur Erzeugung eines Hochstrombogens (19) oder eine Hohlkathode (18) aufweist.

10. Plasma-CVD-Einrichtung nach Anspruch 9, **dadurch gekennzeichnet, dass** sie mit unbewegten, gleichförmig bewegten oder getaktet bewegten Substraten (10) als Durchlaufanlage betrieben wird.

11. Plasma-CVD-Einrichtung nach Anspruch 9, **dadurch gekennzeichnet, dass** die Mittel (15, 17, 18, 19) zur Erzeugung des Plasmas (20) gepulst betrieben werden.

12. Verwendung des Verfahrens nach einem der Ansprüche 1 bis 8 zur Herstellung einer Kohlenstoffschicht, insbesondere einer amorphen Kohlenstoffschicht (a-C:H), oder einer Siliziumschicht, insbesondere einer amorphen Siliziumschicht (a-Si:H) auf dem Substrat (10).

13. Verwendung des Verfahren nach einem der Ansprüche 1 bis 8 zur Herstellung eines mehrlagigen Schichtaufbaus aus einer metallhaltigen Schicht zur Haftvermittlung und einer darauf aufgebrachten amorphen Kohlenstoffschicht, wobei die Übergänge zu den haftungsvermittelnden Schichten als Gradienten über mindestens 1:5 der Einzelschichtdicken ausgeführt werden.

14. Verwendung des Verfahrens nach einem der Ansprüche 1 bis 8 zur Abscheidung eines Schichtsystems, welches Silizium, Bor, Stickstoff, Sauerstoff, Kohlenstoff, ein Metall oder eine Kombination dieser Elemente enthält.

15. Verwendung des Verfahrens nach einem der Ansprüche 1 bis 8 zur Herstellung einer Multilagenstruktur aus alternierenden Einzelschichten.

16. Multilagenstruktur aus alternierenden Hartstoffeinzelschichten und Kohlenstoffeinzelschichten oder Siliziumeinzelschichten, wobei die Hartstoffeinzelschicht aus einem Metall, einem Metallcarbid (MeC), einem Metallsilicid (MeSi), einem Metallcarbosilicid (Me(CSi)), einem Metallsilikonitrid (Me(SiN)), Metallcarbid enthaltenen Kohlenstoff (C-(MeC)), Metallsilicid enthaltenen Silizium (Si-(MeSi)) oder Mischungen aus mindestens zwei der genannten Materialen besteht, wobei das Metall aus der Gruppe Wolfram, Chrom, Niob oder Molybdän ausgewählt ist, und wobei im Fall der Kohlenstoffeinzelschicht die Kohlenstoffeinzelschicht aus amorphem wasserstoffhaltigen Kohlenstoff (a-C:H), amorphem wasserstofffreiem Kohlenstoff (a-C), siliziumhaltigen wasserstoffhaltigem oder wasserstofffreiem Kohlenstoff oder metallhaltigem wasserstoffhaltigem oder wasserstofffreiem Kohlenstoff (C-(MeC)) besteht.

17. Multilagenstruktur nach Anspruch 16, **dadurch gekennzeichnet, dass** im Fall der Siliziumeinzelschicht die Siliziumeinzelschicht aus amorphem wasserstoffhaltigem Silizium (a-Si:H), amorphem wasserstofffreiem Silizium (a-Si), kohlenstoffhaltigem wasserstoffhaltigem oder wasserstofffreiem Silizium oder metallhaltigem wasserstoffhaltigem oder wasserstofffreiem Silizium (Si-(MeSi)) besteht.

18. Multilagenstruktur nach einem der Ansprüche 16 oder 17, **dadurch gekennzeichnet, dass** die Einzelschichten aus einer Art oder mehreren Arten der Hartstoffschicht und einer Art oder mehreren Arten der Kohlenstoff- bzw. der Siliziumschicht bestehen.

19. Multilagenstruktur nach Anspruch 18, **dadurch gekennzeichnet, dass** die Einzelschichten aus einer Art der Hartstoffschicht und einer Art der Kohlenstoff bzw. der Siliziumschicht bestehen.

20. Multilagenstruktur nach einem der Ansprüche 16 bis 19, **dadurch gekennzeichnet, dass** die Dicken der Einzelschichten zwischen etwa 1 und etwa 10 nm und bevorzugt zwischen 2 nm und etwa 5 nm liegen.

21. Multilagenstruktur nach einem der Ansprüche 16 bis 20, **dadurch gekennzeichnet, dass** die Gesamtschichtdicke der Struktur zwischen etwa 1 µm und etwa 10 µm, bevorzugt zwischen etwa 1 µm und etwa 4 µm, liegt.

22. Multilagenstruktur nach einem der Ansprüche 16 bis 21, **dadurch gekennzeichnet, dass** die Hartstoffschicht aus Me, MeC, MeSi, Me(CSi) oder Me(SiN) und die Kohlenstoffschicht aus a-C:H oder a-C besteht.

23. Multilagenstruktur nach einem der Ansprüche 16 bis 22 **dadurch gekennzeichnet, dass** sie aus alternierenden C-(WC)- und a-C:H-Schichten besteht.

24. Multilagenstruktur nach einem der Ansprüche 16 bis 23, **dadurch gekennzeichnet, dass** sie aus alternierenden MeC- und C-(MeC)-Schichten besteht.

25. Multilagenstruktur nach einem der Ansprüche 16 bis 24, **dadurch gekennzeichnet, dass** die Hartstoffschicht aus Me, MeC, MeN, MeSi, Me(CN), Me(CSi) oder Me(SiN) und die Siliziumschicht aus a-Si:H oder a-Si besteht.

26. Multilagenstruktur nach einem der Ansprüche 16 bis 25, **dadurch gekennzeichnet, dass** die Einzelschichten zusätzlich mindestens ein Element aus der Gruppe Silizium. Bor, Stickstoff, Sauerstoff, Kohlenstoff und ein Metall unter der Voraussetzung enthalten, dass nicht gleichzeitig Bor und Kohlenstoff in ihnen vorhanden ist.

27. Verwendung der Multilagenstruktur nach einem der Ansprüche 16 bis 26 zur Beschichtung eines Werkzeuges, insbesondere eines Zerspannwerkzeuges oder eines Umformwerkzeuges.

## Claims

1. Method for vacuum-coating a substrate using a plasma-CVD process, in which a substrate voltage is applied to the substrate in order to control ion bombardment during the coating operation, and the substrate voltage (US) and the coating plasma (20) are generated independently of one another and the substrate voltage (US) is altered during the coating operation, **characterized in that** the substrate voltage (US) used is a bipolar-pulsed DC voltage, the positive and negative pulses of which are set independently of one another in terms of their duration and/or height.

2. Method according to Claim 1, **characterized in that** the substrate voltage (US) is a bipolar-pulsed DC voltage with a frequency of from 0.1 kHz to 10 MHz, in particular 1 kHz to 100 kHz.

3. Method according to Claim 1, **characterized in that** a DC voltage is superimposed on the substrate voltage (US).

4. Method according to Claim 1, **characterized in that** voltage-free interpulse periods lasting from 0 to 1 ms, in particular 2 to 100 µs, are provided between the negative and positive pulses of the substrate voltage (US).

5. Method according to Claim 4, **characterized in that** the interpulse period following a negative pulse is shorter than the interpulse period following a positive pulse.

6. Method according to Claim 1, **characterized in that** gases of various types and in various combinations are added during the coating operation.

7. Method according to Claim 6, **characterized in that** the gases added are passed through the plasma source (18) or are introduced close to the source.

8. Method according to Claim 6, **characterized in that** the reactive gas used is CₓH_{y}, in particular C₂H₂ or CH₄, silanes, siloxanes, in particular SiH₄ or HMDS and derivatives thereof, noble gases, metalorganic compounds or a combination of these gases.

9. Plasma-CVD device for the vacuum-coating of a substrate (10), having a vacuum receptacle (12), a bearing device (11) for holding the substrates (10) that are to be coated, means (15, 17, 18, 19) for generating a plasma (20) in the interior (21) of the receptacle and a device (13), which can be controlled separately from the plasma generation means (15, 17, 18, 19), for generating a substrate voltage (US) which is applied to the substrates (10) that are to be coated, **characterized in that** the device (13) is a DC voltage mains part which can be bipolar-pulsed with durations and/or heights of the positive and negative pulses which can be set separately from one another, and **in that** the means (15, 17, 18, 19) for generating the plasma (20) includes a microwave source (15), a sputtering cathode (17), an arrangement for generating a high-current arc (19) or a hollow cathode (18).

10. Plasma-CVD device according to Claim 9, **characterized in that** it is operated as a continuous installation with substrates (10) which do not move, move uniformly or move cyclically.

11. Plasma-CVD device according to Claim 9, **characterized in that** the means (15, 17, 18, 19) for generating the plasma (20) are operated in pulsed mode.

12. Use of the method according to one of Claims 1 to 8 for producing a carbon layer, in particular an amorphous carbon layer (a-C:H), or a silicon layer, in particular an amorphous silicon layer (a-Si:H) on the substrate (10).

13. Use of the method according to one of Claims 1 to 8, for producing a multilayer structure comprising a metal-containing layer for bonding purposes and an amorphous carbon layer applied to the metal-containing layer, with the transitions to the bonding layers being realized as gradients over at least 1:5 of the individual layer thicknesses.

14. Use of the method according to one of Claims 1 to 8 for depositing a layer system which contains silicon, boron, nitrogen, oxygen, carbon, a metal or a combination of these elements.

15. Use of the method according to one of Claims 1 to 8 for producing a multilayer structure comprising alternating individual layers.

16. Multilayer structure comprising alternating individual hard-material layers and individual carbon layers or individual silicon layers, the individual hard-material layer consisting of a metal, a metal carbide (MeC), a metal silicide (MeSi), a metal carbosilicide (Me(CSi)), a metal siliconitride (Me(SiN)), carbon containing metal carbide (C-(MeC)), silicon containing metal silicide (Si-(MeSi)) or mixtures of at least two of the abovementioned materials, in which the metal is selected from the group consisting of tungsten, chromium, niobium or molybdenum, and in the case of the individual carbon layer the individual carbon layer consisting of amorphous hydrogenated carbon (a-C:H), amorphous unhydrogenated carbon (a-C), silicon-containing hydrogenated or unhydrogenated carbon or metal-containing hydrogenated or unhydrogenated carbon (C-(MeC)).

17. Multilayer structure according to Claim 16, **characterized in that** in the case of the individual silicon layer, the individual silicon layer consists of amorphous hydrogenated silicon (a-Si:H), amorphous unhydrogenated silicon (a-Si), carbon-containing hydrogenated or unhydrogenated silicon or metal-containing hydrogenated or unhydrogenated silicon (Si-(MeSi)).

18. Multilayer structure according to one of Claims 16 or 17, **characterized in that** the individual layers consist of one or more types of the hard-material layer and one or more types of the carbon or silicon layer.

19. Multilayer structure according to Claim 18, **characterized in that** the individual layers consist of one type of the hard-material layer and one type of the carbon or silicon layer.

20. Multilayer structure according to one of Claims 16 to 19, **characterized in that** the thicknesses of the individual layers are between approximately 1 and approximately 10 nm, and preferably between 2 nm and approximately 5 nm.

21. Multilayer structure according to one of Claims 16 to 20, **characterized in that** the total layer thickness of the structure is between approximately 1 µm and approximately 10 µm, preferably between approximately 1 µm and approximately 4µm.

22. Multilayer structure according to one of Claims 16 to 21, **characterized in that** the hard-material layer consists of Me, MeC, MeSi, Me(CSi) or Me(SiN) and the carbon layer consists of a-C:H or a-C.

23. Multilayer structure according to one of Claims 16 to 22, **characterized in that** it comprises alternating C-(WC) and a-C:H layers.

24. Multilayer structure according to one of Claims 16 to 23, **characterized in that** it comprises alternating MeC and C-(MeC) layers.

25. Multilayer structure according to one of Claims 16 to 24, **characterized in that** the hard-material layer consists of Me, MeC, MeN, MeSi, Me(CN), Me(CSi) or Me(SiN) and the silicon layer consists of a-Si:H or a-Si.

26. Multilayer structure according to one of Claims 16 to 25, **characterized in that** the individual layers additionally contain at least one element selected from the group consisting of silicon, boron, nitrogen, oxygen, carbon and a metal, with the proviso that boron and carbon are not simultaneously present in them.

27. Use of the multilayer structure according to one of Claims 16 to 26 for coating a tool, in particular a machining tool or a forming tool.

## Revendications

1. Procédé pour revêtir un substrat par dépôt sous vide avec un procédé par plasma CVD, selon lequel une tension de substrat est appliquée au substrat pour contrôler un bombardement ionique pendant le revêtement, la tension de substrat (US) et le plasma de revêtement (20) sont produits indépendamment l'un de l'autre et la tension de substrat (US) est modifiée pendant le revêtement,
**caractérisé en ce que**
comme tension de substrat (US) on utilise une tension continue pulsée bipolaire dont les impulsions positives et négatives sont réglées en longueur temporelle et/ou en hauteur indépendamment les unes des autres.

2. Procédé selon la revendication 1,
**caractérisé en ce que**
la tension de substrat (US) est une tension continue pulsée bipolaire d'une fréquence de 0,1 kHz à 10 MHz, en particulier de 1 kHz à 100 kHz.

3. Procédé selon la revendication 1,
**caractérisé en ce qu'**
une tension continue est superposée à la tension de substrat (US).

4. Procédé selon la revendication 1,
**caractérisé en ce qu'**
entre les impulsions négatives et positives de la tension de substrat (US) sont prévus des temps de pause hors tension de 0 à 1 ms, en particulier de 2 à 100 µs.

5. Procédé selon la revendication 4,
**caractérisé en ce que**
le temps de pause après une impulsion négative est plus court que le temps de pause après une impulsion positive.

6. Procédé selon la revendication 1,
**caractérisé en ce que**
pendant le revêtement sont ajoutés des gaz de différents types et dans différentes combinaisons.

7. Procédé selon la revendication 6,
**caractérisé en ce que**
les gaz ajoutés sont transmis par la source de plasma (18) ou injectés à proximité de la source.

8. Procédé selon la revendication 6,
**caractérisé en ce que**
comme gaz réactif on utilise du CxHy, en particulier du C₂H₂ ou du CH₄, des silanes, des siloxanes, en particulier du SiH₄ ou du HMDS et ses dérivés, des gaz rares, des composés organométalliques ou une combinaison de ces gaz.

9. Dispositif à plasma CVD pour revêtir par dépôt sous vide un substrat (10) doté d'un récipient sous vide (12), d'un dispositif d'entreposage (11) pour recevoir les substrats à revêtir (10), de moyens (15, 17, 18, 19) pour produire un plasma (20) dans la chambre intérieure (21) du récipient et d'un dispositif (13) contrôlable séparément des moyens de production de plasma (15, 17, 18, 19) pour produire une tension de substrat (US) qui est appliquée aux substrats à revêtir (10),
**caractérisé en ce que**
le dispositif (13) est un bloc d'alimentation en tension continue pulsée bipolaire avec des longueurs et/ou des hauteurs des impulsions positives et négatives réglable séparément les unes des autres et les moyens (15, 17, 18, 19) pour produire le plasma (20) possèdent une source de micro-ondes (15), une cathode de pulvérisation (17), un dispositif pour produire un arc à haute intensité (19) ou une cathode creuse (18).

10. Dispositif à plasma CVD selon la revendication 9,
**caractérisé en ce qu'**
il est utilisé comme installation à passage traversant, avec des substrats immobiles, déplacés uniformément ou déplacés en cadence (10).

11. Dispositif à plasma CVD selon la revendication 9,
**caractérisé en ce que**
les moyens (15, 17, 18, 19) pour produire le plasma fonctionnent de manière pulsée.

12. Utilisation du procédé selon l'une quelconque des revendications 1 à 8, pour fabriquer une couche de carbone, en particulier une couche de carbone amorphe (a-C:H), ou une couche de silicium, en particulier une couche de silicium amorphe (a-Si:H), sur le substrat (10).

13. Utilisation du procédé selon l'une quelconque des revendications 1 à 8, pour la fabrication d'une structure laminaire multicouche à partir d'une couche d'adhésion métallisée et d'une couche de carbone amorphe déposée dessus, les transitions avec les couches d'adhésion étant réalisées sous forme de gradients sur au moins 1:5 de l'épaisseur individuelle des couches.

14. Utilisation du procédé selon l'une quelconque des revendications 1 à 8, pour la précipitation d'un système laminaire qui contient du silicium, du bore, de l'azote, de l'oxygène, du carbone, un métal ou une combinaison de ces éléments.

15. Utilisation du procédé selon l'une quelconque des revendications 1 à 8, pour la fabrication d'une structure multicouche à partir de couches individuelles alternées.

16. Structure multicouche faite d'une alternance de couches individuelles de matière dure et de couches individuelles de carbone ou de couches individuelles de silicium, dans laquelle la couche de matière dure est constituée d'un métal, d'un carbure métallique (MeC), d'un siliciure métallique (MeSi), d'un carbosiliciure métallique (Me(CSi)), d'un siliconitrure métallique (Me(SiN)), de carbone contenant un carbure métallique (C-(MeC)), de silicium contenant un siliciure métallique (Si-(MeSi)) ou de mélanges d'au moins deux des matériaux susmentionnés, dans laquelle le métal est choisi parmi le groupe comprenant le tungstène, le chrome, le niobium et le molybdène, et dans laquelle, dans le cas de la couche individuelle de carbone, la couche individuelle de carbone est constituée de carbone hydrogéné amorphe (a-C:H), de carbone non hydrogéné amorphe (a-C), de carbone hydrogéné ou non hydrogéné silicié ou de carbone hydrogéné ou non hydrogéné métallisé (C-(MeC)).

17. Structure multicouche selon la revendication 16,
**caractérisée en ce que**
dans le cas de la couche individuelle de silicium, la couche individuelle de silicium est constituée de silicium hydrogéné amorphe (a-Si:H), de silicium non hydrogéné amorphe (a-Si), de silicium hydrogéné ou non hydrogéné carboné ou de carbone hydrogéné ou non hydrogéné métallisé (Si-(MeSi)).

18. Structure multicouche selon l'une quelconque des revendications 16 ou 17,
**caractérisée en ce que**
les couches individuelles sont constituées d'un type ou de plusieurs types de couches de matière dure et d'un type ou de plusieurs types de couches de carbone ou de silicium.

19. Structure multicouche selon la revendication 18,
**caractérisée en ce que**
les couches individuelles sont constituées d'un type de couches de matière dure et d'un type de couches de carbone ou de silicium.

20. Structure multicouche selon l'une quelconque des revendications 16 à 19,
**caractérisée en ce que**
les épaisseurs des couches individuelles se situent entre environ 1 et environ 10 nm et de préférence entre 2 nm et environ 5 nm.

21. Structure multicouche selon l'une quelconque des revendications 16 à 20,
**caractérisée en ce que**
l'épaisseur de couches totale de la structure se situe entre environ 1 µm et environ 10 µm, de préférence entre environ 1 µm et environ 4 µm.

22. Structure multicouche selon l'une quelconque des revendications 16 à 21,
**caractérisée en ce que**
la couche de matière dure est constituée de Me, MeC, MeSi, Me(CSi) ou Me(SiN) et la couche de carbone de a-C:H ou a-C.

23. Structure multicouche selon l'une quelconque des revendications 16 à 22,
**caractérisée en ce qu'**
elle est constituée de couches C-(WC) et a-C:H alternées.

24. Structure multicouche selon l'une quelconque des revendications 16 à 23,
**caractérisée en ce qu'**
elle est constituée de couches MeC et C-(MeC) alternées.

25. Structure multicouche selon l'une quelconque des revendications 16 à 24,
**caractérisée en ce que**
la couche de matière dure est constituée de Me, MeC, MeN, MeSi, Me(CN), Me(CSi) ou Me(SiN) et la couche de silicium de a-Si:H ou a-Si.

26. Structure multicouche selon l'une quelconque des revendications 16 à 25,
**caractérisée en ce que**
les couches individuelles contiennent en outre au moins un élément du groupe comprenant le silicium, le bore, l'azote, l'oxygène, le carbone et un métal, sous réserve qu'elles ne contiennent pas simultanément du bore et du carbone.

27. Utilisation de la structure laminaire selon l'une quelconque des revendications 16 à 26, pour revêtir un outil, en particulier un outil d'usinage par enlèvement de copeaux ou un outil de façonnage.
